Europäisches Patentamt

European Patent Office

Office européen des brevets

(19)

(11) Publication number: 0 347 550 A2

(12) EUROPEAN PATENT APPLICATION

(21) Application number: 89107210.0

(22) Date of filing: 21.04.89

(51) Int. Cl.4: H01L 21/82

(30) Priority: 21.06.88 US 209449

(43) Date of publication of application:
27.12.89 Bulletin 89/52

(84) Designated Contracting States:
DE FR GB IT NL

(71) Applicant: TEXAS INSTRUMENTS
INCORPORATED
13500 North Central Expressway
Dallas Texas 75265(US)

(72) Inventor: Seacrist, Michael R.
3247 Summerfield Drive
Grapevine Texas 76051(US)
Inventor: Bell, Kenneth M.
Route 1 Box 33
Windom Texas 75492(US)
Inventor: Trogolo, Joe R.
2712 Glen Forest Lane
Plano Texas 75023(US)
Inventor: James, Felicia Miller
3708 Remington Drive
Carrollton Texas 75007(US)

(74) Representative: Leiser, Gottfried, Dipl.-Ing. et
al
Patentanwälte Prinz, Leiser, Bunke & Partner
Manzingerweg 7
D-8000 München 60(DE)

(54) Process for fabricating isolated vertical and super beta bipolar transistors.

(57) A unified process flow for the fabrication of a super beta NPN transistor, an isolated vertical PNP (VPNP) transistor, and a metal/nitride/polysilicon capacitor includes the simultaneous fabrication of junction isolation regions (36, 46, 120, 122) and a VPNP buried collector (28). Junction isolation is completed by the doping and diffusion of shallow junction isolation regions (46) at the same time that deep collector regions (48) are formed. Base regions (66, 68) for NPN transistors are formed at the same time as a VPNP emitter region (70) and p + collector contact regions (71). NPN emitter regions (74, 76) and a VPNP buried region contact region (81) are doped in the same step as the doping of a polysilicon capacitor electrode (124).

FIG. 4

## PROCESS FOR FABRICATING ISOLATED VERTICAL AND SUPER BETA BIPOLAR TRANSISTORS

### TECHNICAL FIELD OF THE INVENTION

This invention relates in general to the fabrication of different integrated circuit devices using a single semiconductor substrate, and more particularly to a process for fabricating vertical transistors of different conductivity types and the integrated circuit produced thereby.

### BACKGROUND OF THE INVENTION

Operational amplifier designs have always been limited in that conventional PNP integrated circuit transistors used therefor can operate only to around 5 megahertz. These PNP transistors in combination with conventional NPN transistors are typical devices found in operational amplifier integrated circuits.

Recently, a high-frequency isolated vertical PNP (VPNP) transistor has been developed that is superior to the conventional and substrate PNP transistors. This isolated VPNP transistor is capable of 45-volt operation and exhibits a maximum operating frequency around 150 megahertz. The current gain and breakdown voltages on the isolated VPNP transistor are comparable to those achieved on the standard double diffused NPN transistor.. Finally, the isolated VPNP is not limited to the emitter-follower configuration taken by the normal vertical substrate PNP transistor.

Another improved transistor recently developed is the super beta NPN vertical transistor. Super beta NPN transistors achieve a current gain of ten times the normal vertical NPN transistor current gain. Super beta NPN transistors have applications as operational amplifier inputs where their high current gain allows substantially lower level input signals to be amplified.

Another desirable integrated circuit component is the metal/nitride/poly capacitor. The use of nitride in the place of oxide provides a doubling of the capacitance and allows for a dielectric breakdown in excess of 100 volts, and the fabrication of these capacitors on field oxide reduces parasitic junction capacitance and tank leakage currents.

It is therefore desirable to develop a process for the fabrication of an integrated circuit including each of these devices. As yet, no such process has been heretofore developed, limiting circuit designers to the use of one of these circuit devices without the others in any one integrated circuit.

### SUMMARY OF THE INVENTION

One aspect of the present invention comprises a process for fabricating a first vertical transistor of a first conductivity type and a second vertical transistor of a second conductivity type using the same semiconductor substrate. A second transistor collector region of the second conductivity type is formed at a face of a semiconductor substrate of the first conductivity type. A first transistor buried region of the second conductivity type is formed at this face, as spaced from the second transistor collector region. A first transistor collector region of the first conductivity type is then formed at the substrate face and within the buried region.

Next, an epitaxial semiconductor layer of the second conductivity type is formed on the face of the semiconductor substrate. The first and second transistor collector regions are extended upward into the epitaxial layer by thermal diffusion. A deep collector region of the first conductivity type is formed to extend from the outward face of the epitaxial layer to the first transistor collector region. In the next step, a second transistor base region is formed simultaneously at the face of the epitaxial layer with a first transistor emitter region and a first transistor collector contact region, all of the first conductivity type. A second transistor emitter region is thereafter formed at the expitaxial face simultaneously with a first transistor base contact region, both of the second conductivity type.

According to another aspect of the invention, a metal/dielectric/polysilicon capacitor can be formed within the process flow of either the first vertical transistor by itself or within a process flow of both first and second vertical transistors. A further deep junction isolation region of the first· conductivity type is formed at the same time as the first transistor collector region.

Dopant from this further deep juncion isolation region is up-diffused into the epitaxial layer at the same time as dopant from the first transistor collector region and the buried region. A shallow junction isolation region of the first conductivity type is formed in the epitaxial layer at the same time that the deep collector region of the vertical transistor is formed. Dopant from the shallow junction isolation region is down-diffused such that the deep and shallow junction isolation regions form a continuous additional junction isolation region.

During subsequent diffusion steps, a thick layer of field oxide is formed over this additional junction isolation region. A polysilicon layer is deposited, patterned and etched on top of the field oxide layer, and is preferably doped simultaneously with the formation of the first transistor base contact.

According to a further aspect of the invention, the second transistor can be a super beta NPN transistor by inserting a further doping and diffusion step in the process to create a super beta base region of the first conductivity type.

The incorporation of the fabrication steps of these devices into a single process flow has the advantage of greatly reducing the number of mask levels required for the separate fabrication of each. An integrated circuit containing these three devices gives integrated circuit designers much more leeway and flexibility than the more conventional devices that they supplement. The combination of the VPNP transistor, the super beta vertical NPN transistor and the metal/nitride/polysilicon capacitor in a single integrated circuit provides unique high performance circuit design opportunities. The current gain on both a super beta NPN transistor and a conventional NPN vertical transistor can be advantageously set simultaneously by a single emitter diffusion. The double (up and down) diffused isolation preferably used in the construction of the devices of the invention allows for a tighter design layout and can save up to 25% layout area on spacing relative to single diffusion isolation.

## BRIEF DESCRIPTION OF THE DRAWINGS

Other aspects of the invention and their advantages will become apparent by referring to the following detailed description in conjunction with the drawings in which:

FIGURES 1-4 are greatly enlarged schematic sections showing successive stages of fabricating a vertical PNP transistor, a conventional vertical NPN transistor and a vertical super beta NPN transistor according to the invention; and

FIGURE 5 is a greatly enlarged schematic sectional view of a metal/nitride/polysilicon capacitor that can be fabricated in conjunction with the devices fabricated in FIGURES 1-4.

## DETAILED DESCRIPTION OF THE INVENTION

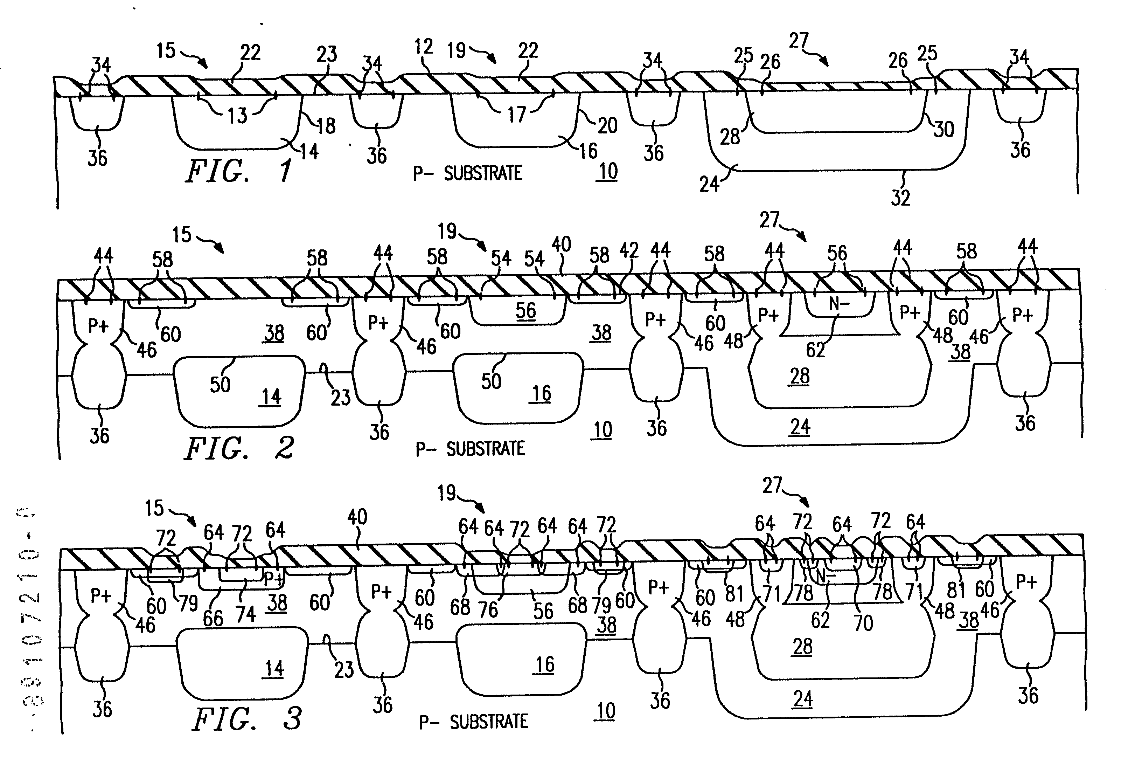

Referring first to FIGURE 1, a (p-) silicon substrate 10 is shown in a greatly enlarged and schematic view. Silicon substrate 10 may have either (100) or (111) crystallographic orientation, although (111) orientation is preferred. An initial oxide layer 12, here shown after several patternings, etches and regrowths of replacement oxide, is grown on substrate 10. After this, a portion of oxide layer 12 between limits 13 (schematically shown by hash marks) is removed using conventional pattern-and-etch techniques to create a mask for the implantation of an (n-) buried collector region 14 for an NPN vertical transistor in a conventional NPN transistor area indicated generally at 15. At the same time, an (n+) buried collector region 16 is masked in oxide layer 12 to limits 17 in a super-beta NPN transistor area indicated generally at 19. The sheet resistance of the buried collector regions 14 and 16 should be approximately 15 Ohms/square, and a preferred dopant is antimony.

After the implantation of the dopant, substrate 10 is subjected to a thermal diffusion step to give the respective approximate conductivity type boundaries 18 and 20 of the buried collector regions 14 and 16 as shown. During this and subsequent thermal diffusion steps, oxide portions, such as portions 22, will grow back wherever the outer surface 23 of the silicon substrate 10 has been exposed by the previous oxide removal step.

Next, oxide layer 12 is removed to limits 25 and an (n-) buried region 24 is implanted and thermally diffused within a vertical PNP transistor area indicated generally at 27. The dopant concentration used to implant buried region 24 is much less than that of collector regions 14 and 16, as using the same dopant level would overwhelm the vertical PNP collector region subsequently formed and described immediately below.

In a similar manner, the oxide layer 12 is again removed within limits 26 to mask an implantation step for forming a (p) vertical PNP transistor collector region 28. A preferred implanted dopant species is boron. The (p) dopant is diffused by means of a thermal cycle such that the approximate final limit between (p) type and (n) type material is marked by boundary 30. The distance between boundary 30 of vertical transistor collector region 28 and the boundary 32 of buried region 24 must be sufficient to isolate collector region 28 from the (p-) substrate 10, and to withstand more than the maximum operating voltage potential and not have a punch-through voltage breakdown.

Simultaneously with the removal of oxide from layer 12 within limits 26, oxide is removed within limits 34 such that the (p) type dopant implanted into region 28 will also be implanted into a plurality of deep junction isolation regions 36. Regions 36 are provided to isolate the devices from each other such that parasitic transistor devices will not be formed.

Turning now to FIGURE 2, oxide layer 12 is stripped and an (n-) epitaxial silicon layer 38 is grown on the surface 23 of semiconductor substrate 10. A second oxide layer 40 is grown from an outer surface 42 of epitaxial layer 38.

Oxide layer 40 is next removed within limits 44 to provide a mask for the next implantation step, which is a heavy deposition of (p) type dopant. The (p) dopant is diffused in a subsequent thermal cycle to create shallow (p+) junction isolation regions 46 and a (p+) deep collector region 48.

Each shallow isolation region 46 overlies a respective deep isolation region 36, and region 48 overlies VPNP buried collector region 28. Deep collector region 48 is preferably annular or otherwise endless.

The deposition of the (p) dopant is followed by a thermal diffusion drive-in step such that shallow junction isolation regions 46 become continuous with deep junction isolation regions 36, and such that deep collector region 48 will become continuous with buried collector region 28. In this diffusion step, dopant diffuses upwardly from semiconductor substrate 10 at the same time that dopant diffuses downwardly from the surface of epitaxial layer 38. This up-diffusion establishes upper boundaries 50 of collector regions 14 and 16 and upper boundary 52 of VPNP collector region 28.

In the various diffusion steps conducted, it is important to balance the thermal cycles in order to get the proper amount of diffusion. Hence, earlier-created structures should be subjected to a less severe thermal cycle than later-created structures if all other parameters are the same, because the later thermal cycles will affect the extent and concentrations of earlier created structures as well as the later ones.

In super beta vertical NPN transistor area 19, oxide layer 40 is removed from an area within limits 54 to mask a super beta implantation step that is done with a (p) type dopant such as boron. A thermal diffusion drive-in step is then performed such that a super beta base region 56 results. Super beta base region 56 should have a sheet resistance of approximately 5000 Ohms/square.

Next, oxide layer 40 is removed within limits 56 and an (n) type dopant is implanted therein. Subsequently, oxide layer 40 is removed within limits 58 to permit the implantation of an (n) type dopant such as antimony. After this implantation, a thermal diffusion drive-in step is conducted on epitaxial layer 38 such that the (n) type dopant implanted between limits 56 and between limits 58 diffuses to create threshold adjust regions 60 and VPNP base region 62. Threshold adjust regions 60 are desirable to prevent parasitic PMOS transistors between (p) diffusions, such as diffused regions 46 and 48. Threshold adjust regions 60 control the junction breakdown voltage such that it can exceed the standard 45-volt operating voltage.

Turning now to FIGURE 3, a portion of oxide layer 40 is removed within limits 64 in NPN transistor area 15, super beta transistor area 19 and VPNP transistor area 27. Then, a (p) type dopant is deposited and thermally diffused to create a (p+) NPN transistor base region 66, an annular or otherwise endless (p+) super beta contact region 68, a VPNP transistor (p+) emitter region 70 and an annular or endless (p+) contact region 71 inside VPNP collector contact region 48. After this step, high sheet resistance resistors (not shown) may be patterned by removal of certain portions of oxide layer 40 (not shown) with a subsequent oxidation and implantation to create the resistors (not shown) in layer 38.

Next, oxide is removed from oxide layer 40 down to the surface of the epitaxial layer 38 within limits 72 in all three device areas 15, 19 and 27 for masking the deposition of an (n) type dopant. The dopant thus deposited is subsequently thermally diffused to create a conventional vertical NPN emitter region 74, a super beta emitter region 76, a vertical PNP base contact region 78, collector contact regions 79 for the conventional NPN transistor and the super beta NPN transistor, and a buried region contact 81 for ohmic contact to buried region 24. In the embodiment shown, base contact region 78 is annular or otherwise endless.

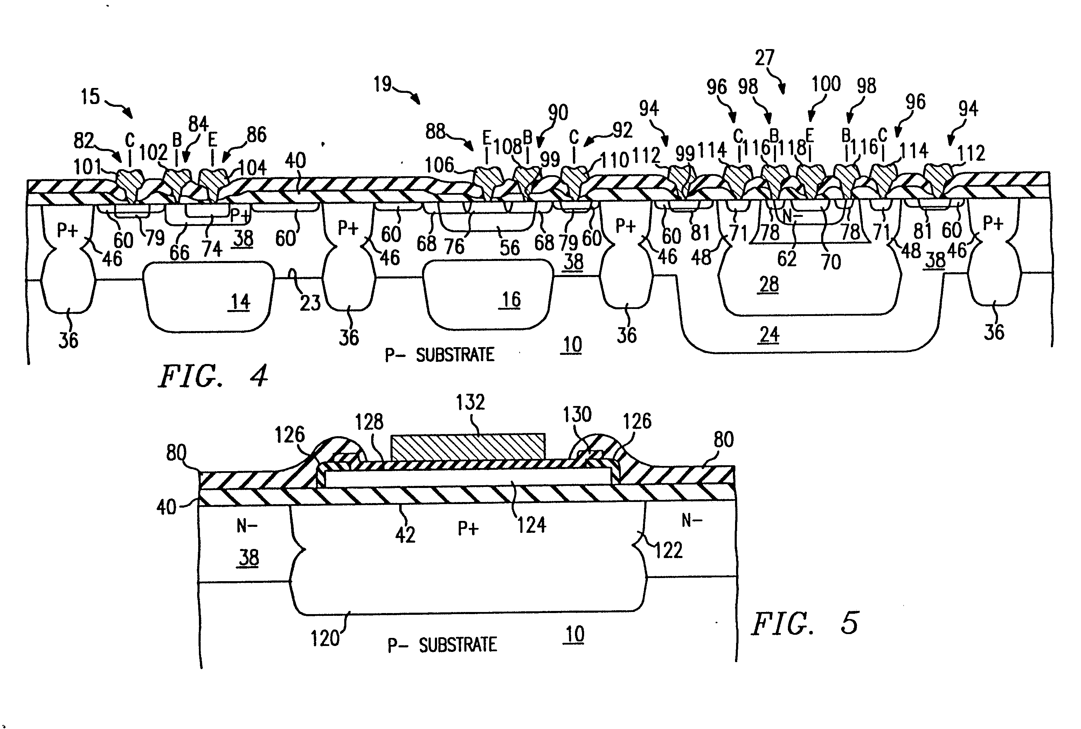

The final steps of the preferred process are shown in FIGURE 4. The photoresist is stripped and a middle-level oxide layer 80 is deposited over the surface of oxide layer 40. Middle-level oxide layer 80 is then densified in a thermal step. A plurality of contact orifices 82-96 are next patterned and are etched into middle-level oxide layer 80. The middle-level oxide layer 80 is then reflowed into the contact orifices 82-96 to produce sloping sidewalls thereof. A respective orifice 98 in field oxide layer 40 is opened below each contact orifice 82-96 to expose the surface 42 of the epitaxial layer 38 therebeneath. Metal leads 101-118 are then deposited, patterned and etched according to conventional methodology. A passivating nitride layer (not shown) is preferably added thereafter to passivate the exposed surface of the completed integrated circuit.

FIGURE 5 is a greatly enlarged schematic cross sectional view of a capacitor that can be formed during the fabrication process of the other devices above described, with like numbers identifying like structure as appropriate. In a separate area of (p) type semiconductor substrate 10, a deep isolation junction region 120 is implanted with a (p) type dopant at the same time that buried collector region 28 (FIGURE 1) is implanted. After the epitaxial layer 38 has been grown on semiconductor substrate 10 and a second oxide layer 40 has been grown on epitaxial layer 38, an orifice (not shown) is opened into oxide layer 40 and a (p) type dopant is deposited on the surface 42 of layer 38 at the same time that the (p) type deposition is performed for shallow junction isolation regions 46 and deep collector region 48 (FIGURE 2). Next, a thermal diffusion step is performed that up-diffuses dopant from region 120 and down-diffuses the dopant deposited on the surface 42 of epitaxial layer 38. This combined up-diffusion and down-diffusion creates a continuous junction isolation region 122 that extends from epitaxial surface 42 into semiconductor substrate 10.

Prior to the doping/diffusion sequence that creates emitter regions 74 and 76 and VPNP base contact region 78 (FIGURE 3), a polycrystalline silicon layer is deposited, patterned with a photoresist mask, and etched to form a polysilicon electrode 124. Electrode 124 is rendered conductive by a heavy deposition of the (n) type dopant used to create emitter regions 74 and 76 and VPNP base contact region 78. The diffusion step by which the emitter dopant is diffused into regions 74, 76 and 78 will at the same time cause an oxide layer 126 to grow from the exposed surface of polysilicon electrode 124.

Oxide layer 126 is removed within a central region 128 of the outer polysilicon surface. This central region 128 then has deposited on it a nitride dielectric layer 130 that is patterned and etched using conventional photoresist masking techniques to leave the portion of layer 130 shown.

Middle level oxide layer 80 is deposited, densified, a contact opened therein, and reflowed at the same time that these steps are performed on the middle level oxide layer 80 as shown in FIGURE 4. Finally, an outer metal electrode 132 is deposited, patterned and etched at the same time that metal contacts 101-118 are formed.

In summary, a unified process for the fabrication of a super beta vertical NPN transistor, a vertical PNP transistor and a metal/nitride/polysilicon capacitor in a single integrated circuit has been shown and described. The unified process eliminates many masking steps and permits increased flexibility in circuit design.

While preferred embodiments of the invention have been shown and described in the above Detailed Description, the invention is not limited thereto but only by the scope and spirit of the appended claims.

## Claims

1. A process for fabricating a first vertical transistor of the first conductivity type and a second transistor of a second conductivity type using a single semiconductor substrate of a first conductivity type, comprising the steps of:
forming a second transistor collector region of the second conductivity type at a face of the semiconductor substrate;
forming a first transistor buried region of the second conductivity type at the face and spaced from the second transistor collector region;
forming a first transistor collector region of the first conductivity type at the face and within the buried region;
forming an epitaxial semiconductor layer of the second conductivity type on the face of the semiconductor substrate;
extending the first and second transistor collector regions into the epitaxial layer by thermal diffusion;
forming a first transistor deep collector region of the first conductivity type to extend from an outer face of the epitaxial layer to the first transistor collector region;
simultaneously forming a second transistor base region and first transistor emitter region of the first conductivity type at the face of the epitaxial layer, the second transistor base region formed over and spaced from the second transistor collector region, the first transistor emitter region formed over and spaced from the first transistor collector region and laterally spaced from the first deep collector region;
forming a first transistor base region of the second conductivity type at the face of the epitaxial layer around the first transistor emitter region and spaced from the deep collector region and the first transistor collector region; and
simultaneously forming a second transistor emitter region and a first transistor base contact region of the second conductivity type at the face of the epitaxial layer, the second transistor emitter region formed within the second transistor base region, and the first transistor base contact region formed to be in contact with the first transistor base region and spaced from the first transistor deep collector region and the first transistor emitter region.

2. The process of Claim 1, wherein the first transistor is a PNP transistor and the second transistor is an NPN transistor.

3. The process of Claim 1, and further comprising the steps of:
forming a deep junction isolation region to be of the first conductivity type in the semiconductor substrate at the same time as said step of forming the first transistor collector region therein, the deep junction isolation region formed in between the second transistor collector region and the first transistor collector region; and
forming at least one shallow junction isolation region of the first conductivity type in the epitaxial layer over the deep junction isolation region at the same time as said step of forming the deep collector region, such that the shallow junction isolation region and the deep junction isolation region are joined.

4. The process of Claim 3, and further comprising the step of:
forming a field adjust region with a dopant of the second conductivity type at the face of the epitaxial layer to be disposed between the second transistor base region and the shallow junction isolation region.

5. The process of Claim 3, and further comprising the steps of:

simultaneously up-diffusing dopant from the deep junction isolation region and from the first transistor collector region into the epitaxial layer; and simultaneously down-diffusing dopant from the shallow isolation junction region and from the deep collector region, such that the deep collector region makes contact with the first transistor collector region and such that the shallow and deep junction isolation regions become continuous.

6. The process of Claim 1, and further comprising the step of down-diffusing dopant from the first transistor deep collector region until the deep collector region becomes continuous with the first transistor collector region.

7. The process of Claim 1, and further comprising the step of forming a first oxide layer across an outer face of the semiconductor substrate; and prior to each of said respective steps of forming the second transistor collector region, forming the first transistor buried region and forming the first transistor collector region, removing for each said respective step a respective predetermined portion of the oxide layer so that the oxide layer acts as a doping mask for said respective step.

8. The process of Claim 1, and further comprising the steps of:

after said step of forming the epitaxial semiconductor layer, forming an oxide layer on an outer face of the epitaxial layer; and prior to each of said respective steps of forming the deep collector region, forming the second transistor base region, and forming the first transistor base region, removing a respective portion of the oxide layer to act as a respective dopant mask for said respective step.

9. The process of Claim 1, and further comprising the step of forming a super beta region of the first conductivity type at the face of the epitaxial layer over and spaced from the second transistor collector region, the super beta region formed to be disposed around the second transistor emitter region and to connect to the second transistor base region.

10. The process of Claim 1, and further comprising the steps of:

forming a second deep junction isolation region of the first conductivity type in the substrate at the same time as said step of forming the first transistor collector region; and forming a capacitor over the second junction isolation region.

11. The process of Claim 10, and further comprising the step of forming a second shallow junction isolation region of the first conductivity type in the expitaxial layer for the capacitor at the same time as said step of forming the deep collector region, such that the second deep junction isolation region and the second shallow junction isolation region will become a continuous second junction isolation region.

12. The process of Claim 11, and further comprising the steps of:

forming an oxide layer on the expitaxial layer; and forming a capacitor on the oxide layer over the second junction isolation region.

13. The process of Claim 1, wherein a capacitor is formed in a capacitor area of the semiconductor substrate spaced from the vertical transistor and the lateral transistor, said process further including the steps of:

forming a polycrystalline silicon capacitor electrode to be insulatively spaced over the epitaxial layer in the capacitor area; and doping the polycrystalline silicon electrode to be highly conductive at the same time as said step of forming the second transistor emitter region and the first transistor base contact region.

14. The process of Claim 1, and further including the step of forming a second transistor collector contact region of the second conductivity type at the outer face of the expitaxial layer over the second transistor collector region and spaced from the second transistor base region, at the same time as said step of simultaneously forming the second transistor base region and the first transistor emitter region.

15. An integrated circuit fabricated according to the process of Claim 1.

16. A process for fabricating a vertical transistor and a capacitor using a single semiconductor substrate of a first conductivity type, comprising the steps of:

forming a buried region of a second conductivity type at a face of the semiconductor substrate; simultaneously forming a collector region and a deep junction isolation region at the face of the first conductivity type, the collector region formed within the buried region and the junction isolation region formed to be spaced from the buried region; forming an epitaxial layer of the second conductivity type on the face; forming an insulator layer on an outer face of the epitaxial layer; up-diffusing dopant to extend the collector region and the deep junction isolation region into the epitaxial layer; simultaneously forming a deep collector region and a shallow junction isolation region of the first conductivity type at the outer face of the epitaxial layer, the deep collector region disposed over the collector region and extending thereto, the shallow junction isolation region formed over the deep junction isolation region and to be continuous therewith; forming a base region of the second conductivity type at the face of the epitaxial layer over the collector region and spaced from the collector region and the deep collector region;

forming a polycrystalline layer including silicon on the insulator layer over the junction isolation region;

forming a dielectric layer on the polycrystalline layer;

forming a middle-level insulating layer over the polycrystalline layer and the insulating layer;

opening orifices in the middle-level insulating layer to the polycrystalline layer and to respective regions of the insulating layer over the base region and a contact region in ohmic contact with the buried region;

removing the respective regions of the insulating layer to expose selected portions of the base region and the contact region; and

simultaneously doping the polycrystalline layer and the portions to respectively form a conductive capacitor electrode, a base contact region, and a buried region contact region.

17. The process of Claim 16, wherein said vertical transistor comprises a vertical PNP transistor.

18. The process of Claim 16, wherein said insulator layer comprises silicon dioxide, the process comprising the further step of thermally growing the oxide layer during said steps of up-diffusing dopant, simultaneously forming the collector contact and shallow isolation regions, and forming the base region.

19. The process of Claim 16, and further comprising the steps of:

diffusing dopant into the face of the epitaxial layer to form a vertical transistor base contact;

at the same time as said step of diffusing dopant, growing an oxide layer over said polycrystalline layer; and

removing the oxide layer from a selected portion of the polycrystalline silicon layer prior to said step of forming the dielectric layer on the polycrystalline layer.

20. An integrated circuit formed according to the process of Claim 16.

21. In a process for the simultaneous fabrication of a first transistor of a first conductivity type and a second transistor of a second conductivity type at a face of a semiconductor substrate of the second conductivity type, the method comprising the steps of:

simultaneously forming a second transistor buried collector in a second transistor area and a plurality of deep junction isolation regions on boundaries of the second transistor area and of a first transistor area at the face, the buried collector and deep junction isolation regions being of a second conductivity type;

forming an epitaxial layer of the first conductivity type on the substrate;

simultaneously forming at least one deep collector region over the second transistor buried collector and a plurality of shallow junction isolation regions over respective deep junction isolation regions, the deep collector region and the shallow junction regions formed to be of the second conductivity type;

diffusing dopant in the second transistor buried collector region, the deep collector region, the deep junction isolation regions and the shallow junction isolation regions such that each shallow junction isolation region becomes continuous with a respective deep junction isolation region and such that the deep collector region becomes continuous with the buried collector region;

simultaneously forming a first base region in the first transistor area and a second transistor emitter region in the second transistor area, both formed at an outer face of the epitaxial layer and to be of the second conductivity type; and

simultaneously forming a second transistor base contact region in the second transistor area and a first transistor emitter region within the first transistor base region, the second transistor base contact region and the first transistor emitter region formed at the outer face of the epitaxial layer and to be of the first conductivity type.

*FIG. 1*

*FIG. 2*

*FIG. 3*

FIG. 4

FIG. 5

EP 0 347 550 A2